# EUROPÄISCHE PATENTSCHRIFT

(11) **EP 1 032 023 B1**
(45) Veröffentlichungstag und Bekanntmachung des Hinweises auf die Patenterteilung: **05.09.2007**
(21) Anmeldenummer: 00102733.3
(22) Anmeldetag: 10.02.2000
(51) Int. Cl.: H01L 21/00

(54) **Verfahren sowie Anordnung zum kontinuierlichen Behandeln von Gegenständen**
Method and arrangement for continuously treating objects
Méthode et agencement pour traiter continuellement des objets

(30) Priorität: 22.02.1999 DE 19907601
(43) Veröffentlichungstag der Anmeldung: 30.08.2000
(73) Patentinhaber: SCHOTT Solar GmbH, 63755 Alzenau (DE)
(72) Erfinder: Lauinger, Thomas, 63843 Niedernberg (DE); Aberle, Armin, Botany NSW 2019 (AU); Auer, Richard, 91074 Herzogen-Aurach (DE); Halbach, Guido, 30167 Hannover (DE); Kanne, Manuel, 32689 Kalletal (DE); Paschke, Hanno, 30451 Hannover (DE); Moschner, Jens, 27404 Zeven (DE)
(74) Vertreter: Stoffregen, Hans-Herbert

(56) Entgegenhaltungen:
- WO-A-99/60612
- DE-A- 4 303 462
- US-A- 3 973 665
- US-A- 4 947 784

## Beschreibung

Die Erfindung bezieht sich auf ein Verfahren zum kontinuierlichen Behandeln von Gegenständen in einer Bearbeitungseinrichtung, insbesondere zur Oberflächenbehandlung von plattenförmigen Gegenständen wie Halbleiterbauelementen, vorzugsweise Siliziumwafern, wobei die Gegenstände entlang einer die Bearbeitungseinrichtung durchsetzenden Transportbahn mittels einer ersten linear wirkenden eine Hin- und Herbewegung ausübenden Fördereinrichtung bewegt werden und wobei die Gegenstände über eine Übergabeeinrichtung auf die Transportbahn aufgegeben bzw. von dieser entnommen werden. Ferner bezieht sich die Erfindung auf eine Anordnung zur kontinuierlichen Behandlung wie Oberflächenbehandlung von auf Trägern angeordneten Gegenständen, insbesondere plattenförmigen Gegenständen wie Halbleiterbauelementen, vorzugsweise Siliziumwafern, umfassend eine eine Bearbeitungseinrichtung durchsetzende Transportbahn sowie Übergabeeinrichtungen zum Aufgeben bzw. Entnehmen der Träger auf die bzw. von der Transportbahn.

Die Oberflächenbehandlung von Gegenständen ist in vielen Bereichen der Industrie ein unverzichtbarer Bestandteil in der Herstellung verschiedenster Produkte. Insbesondere die Beschichtung von Gegenständen mit dünnen Oberflächenschichten ist weitverbreitet, um gewünschte Produkteigenschaften zu erhalten oder langfristig zu garantieren. Als Beispiele seien z. B. die Beschichtung von Stahlwerkzeugen mit dünnen abriebfesten Schichten zur Verschleißminderung oder die Beschichtung von Brillengläsern mit dünnen optisch aktiven Schichten zur Reflexionsminderung genannt. In der Photovoltaikindustrie werden Solarzellen mit dünnen Oberflächenbeschichtungen z. B. einer Dicke von 80 nm versehen, wodurch sich deren energetischer Wirkungsgrad auf Grund verschiedener physikalischer Effekte um bis zu 30 % erhöhen lässt.

Beschichtungsprozesse finden teilweise bei Atmosphärendruck, häufig jedoch bei Niederdruck statt. Niederdruck ist z. B. erforderlich, um eine ausreichende Homogenität der Beschichtung über der Oberfläche des Gegenstandes zu erzielen. Häufig sind auch bestimmte Abscheidetechniken erst bei Niederdruck möglich. Als bekannter Beschichtungsprozess ist die Niederdruck-Gasphasenabscheidung zu nennen. Dabei wächst die Oberflächenbeschichtung durch eine Reaktion von einem oder mehreren Gasen, die thermisch oder elektrisch in Form von Plasmaanregung aktiviert werden.

Die kontinuierliche Beschichtung auf bewegte Gegenstände wird angewendet, um die flächenhafte Homogenität der Beschichtung zu verbessern. Hierbei genügt es, wenn die Beschichtungseinrichtung in einer Dimension homogen abscheidet, und zwar in Richtung quer zur Transportrichtung der Gegenstände. Im Gegensatz dazu ist bei einer Beschichtung auf stillstehende Gegenstände eine zweidimensional homogene Abscheidung erforderlich, also über die gesamte Oberfläche des Gegenstandes. Dies führt technologisch zu einem hohen Mehraufwand.

Die für eine kontinuierliche Beschichtung erforderliche stetige Bewegung der Gegenstände relativ zur Beschichtungsquelle erfolgt durch eine Transportmechanik. Diese bewegt entweder unmittelbar die zu beschichtenden Gegenstände oder Werkstückträger, die die Gegenstände aufnehmen.

Werkstückträger zur Aufnahme der zu beschichtenden Gegenstände werden eingesetzt, sofern die Gegenstände nicht flächig und/oder die Gegenstände zerbrechlich sind und/oder die Gegenstände nicht mit Materialien der Transportmechanik in Kontakt treten dürfen und/oder die Werkstückträger eine Dichtfunktion zwischen Atmosphäre und Niederdruckbereich ausüben müssen. Als Werkstückträger kommen in der Regel Platten aus Stahl, Glas, Graphit oder Keramik zum Einsatz, die Aussparungen zur Aufnahme der Gegenstände aufweisen.

Rollen-, Ketten- und Schubantriebe können als Transportmechanik benutzt werden. Dabei laufen bei einem Rollantrieb die vorzugsweise plattenförmigen Gegenstände bzw. die Werkstückträger auf einem System von Rollen oder Walzen, welche aktiv angetrieben werden.

Bei einem Kettenantrieb werden die Gegenstände über Mitnehmer auf einer Transportkette bewegt. Leichte Gegenstände/Werkstückträger können direkt auf der Kette laufen. Ab einem bestimmten Gewicht müssen zusätzliche passiv mitlaufende Rollen zur Lastaufnahme eingesetzt werden.

Bei einem Schubantrieb werden die Gegenstände bzw. Werkstückträger in einer lückenlosen Endlosreihe durch die Bearbeitungsanlage geschoben. Dabei wird nur der hinterste Gegenstand/Werkstückträger angeschoben, welcher seine Bewegung dann auf alle vor ihm befindlichen überträgt. Durch den Schubantrieb bedingt ist eine kontinuierliche Bewegung nicht möglich, da während der Rückwärtsbewegung des Schubelementes die komplette Reihe von Gegenständen/Werkstückträgern zum Stillstand kommt. Allerdings sind Schubantriebe bezüglich parasitärer Abscheidung und hohen Temperaturen unempfindlich.

Mit Rollen- oder Kettenantrieben ist der Übergang von einer getakteten in eine kontinuierliche Bewegung möglich, indem verschiedene Rollen- bzw. Kettensegmente mit unterschiedlichen Geschwindigkeiten laufen. Dies erlaubt den Einsatz dieser Systeme in NiederdruckAnlagen, welche die Gegenstände/Werkstückträger nur getaktet über Schleusen ein- und ausführen können.

Die für einen kontinuierlichen Transport geeigneten Antriebssysteme Rollen- bzw. Kettenantrieb sind problematisch bezüglich parasitärer Abscheidung und Anwendung unter hohen Temperaturen. Parasitäre Abscheidung tritt z. B. bei plasmaunterstützter Niederdruckabscheidung aus der Gasphase auf. Hierbei ist es nur mit unverhältnismäßig hohem Aufwand zu verhindern, dass Rollenlager und/oder Kettenglieder ebenfalls beschichtet und damit innerhalb kurzer Zeit schwergängig werden. Bei Anwendung hoher Temperaturen während der Bearbeitung der Gegenstände müssen aktiv angetriebene Rollen oder Ketten ausreichend vor Überhitzung geschützt werden. Dies erfordert ebenfalls aufwendige Maßnahmen.

Die derzeit verfügbaren Werkstückträger sind problematisch in Anlagen, die bei hohen Temperaturen und mit hohen Durchsätzen arbeiten. Um bei hohen Temperaturen eine ausreichende Verzugsfestigkeit zu erreichen, müssen die Werkstückträger massiv ausgelegt werden. Dadurch besitzen sie eine hohe Wärmekapazität, die zu hohen Energieverlusten führt, wenn die Träger in kurzer Folge aufgeheizt und außerhalb der Beschichtungszone wieder abgekühlt werden müssen. Um in Niederdruckanlagen hohe Durchsätze zu erzielen, müssen die Schleusenkammern, in denen sich die Träger befinden, möglichst schnell evakuiert werden. Dies ist kritisch, sofern die Schleusenkammer aus z. B. technischen Gründen nur eine Abpumpöffnung besitzt. In diesem Fall muss die ausströmende Luft um den Träger herum strömen, wodurch der Evakuierungsprozess verlangsamt wird. Das Einbringen von Strömungsöffnungen ist aus Stabilitätsgründen nur bedingt möglich. Im Falle von plattenförmigen Gegenständen müsste dazu der Abstand der einzelnen Gegenstände zunehmen. Dies ist jedoch allein aus Durchsatzgründen unerwünscht.

Der DE 43 03 462 C2 ist eine Mehrkammer-Beschichtungsanlage zu entnehmen, in der Substrate wie Flachgas behandelt werden. Die Substrate werden dabei beabstandet auf Trägern angeordnet durch die Beschichtungsanlage gefördert. Hierzu sind Gleitelemente wie Rollen vorgesehen, die einen Transport mit konstanter Geschwindigkeit durch die Beschichtungskammern ermöglichen.

Die US 3,973,665 bezieht sich auf eine Transportvorrichtung zum Behandeln von Halbleitersubstraten durch z.B. Sputtern. Zum Fördern der Gegenstände werden diese von Trägern aufgenommen, die beabstandet zueinander transportiert werden. Hierzu ist ein Förderbalken vorgesehen, um die Träger von einer Bearbeitungsstation zu einer anderen zu fördern. Ferner ist es erforderlich, dass die Träger von weiteren senkrecht zur Bewegung des Hubbalkens verfahrbaren Liftern erfaßt werden, um beim Zurückbewegen des Hubbalkens die Träger in Ausgriff mit diesem zu bringen.

Die GB 2 143 910 A bezieht sich auf ein System von aneinanderreihbaren Trägern zur Aufnahme von Gegenständen, die in einer Unterdruckkammer behandelt werden sollen. Die Träger selbst weisen geometrisch angepaßte ineinandergreifende Ränder auf, die eine Dichtfunktion beim Einführen in die Unterdruckkammer ausüben. Aus der JP 10067429 A ist eine Fördervorrichtung für Substrate bekannt, die auf einem Träger anordbar sind, der seinerseits von einer Spindel entlang von Schienen verfahrbar ist. Ein Spindelantrieb zum Transportieren von zu behandelnden Wafern wird auch in der US 4,947,784 beschrieben. Die die Träger aufnehmenden Schlitten werden dabei von der Spindel durchsetzt. Aus der DE 197 45 646 A1 ist eine Transportvorrichtung bekannt, die Pendelförderer und Trägerhebemechanismen umfaßt, um Halbleiter durch Teststationen zu führen.

Der vorliegenden Erfindung liegt das Problem zugrunde, ein Verfahren und eine Anordnung der zuvor beschriebenen Art so weiterzubilden, dass mit konstruktiv einfachen Maßnahmen ein kontinuierliches Behandeln wie Beschichten von insbesondere flächigen Gegenständen möglich ist, wobei weder parasitäre Abscheidungen noch hohe Temperaturen den Verfahrensablauf negativ beeinträchtigen sollen.

Verfahrensgemäß wird das Problem im Wesentlichen dadurch gelöst, dass die Gegenstände auf Trägern angeordnet werden, die mittels zumindest zwei erste linear wirkende eine Hin- und Herbewegung ausübende Fördereinrichtungen auf der Transportbahn aneinandergereiht und sodann kontinuierlich durch die Bearbeitungseinrichtung gefördert werden, wobei das Aneinanderreihen und sodann kontinuierliche Fördern der Träger derart erfolgt, dass eine der ersten Fördereinrichtungen einen auf die Transportbahn übergebenen Träger an auf der Transportbahn vorhandenen Trägern anreiht, während die andere erste Fördereinrichtung die zuvor aneinandergereihten Träger kontinuierlich fördert. Die Gegenstände bzw. Träger selbst werden durch die Bearbeitungseinrichtung mit im wesentlichen konstanter Geschwindigkeit gefördert.

In Weiterbildung der Erfindung wird ein die Behandlungs- oder Bearbeitungseinrichtung verlassender Gegenstand bzw. ein diesen aufnehmender Träger von den verbleibenden aneinandergereihten Gegenständen durch eine zweite Fördereinrichtung vereinzelt und auf eine die Gegenstände bzw. Träger von der Transportbahn wegführende Übergabeeinrichtung ausgerichtet.

Als erste linear wirkende Fördereinrichtung werden vorzugsweise Paare von Schubstangen und als zweite Fördereinrichtung ein Paar von Zugstangen verwendet.

Eine Anordnung der eingangs genannten Art zeichnet sich insbesondere dadurch aus, dass der Transportbahn zum Transportieren der die Gegenstände aufnehmenden Träger vor der Bearbeitungseinrichtung zumindest zwei erste linear wirkende eine Hin- und Herbewegung ausübende Fördereinrichtungen zugeordnet sind, die abwechselnd einzelne Träger getaktet an auf der Transportbahn aneinandergereihten Trägern anreihen und aneinandergereihte Träger kontinuierlich durch die Bearbeitungseinrichtung fördern, und dass der Transportbahn zum Fördern von behandelte Gegenstände aufweisenden Trägern zumindest eine zweite Fördereinrichtung zugeordnet ist, die aneinandergereihte Träger zum Ausrichten auf die Übergabeeinrichtung zum Entnehmen des Trägers von der Transportbahn vereinzelt.

Jeder Träger weist einen Rahmen auf, der auf die Transportbahn vorgebenden Führungsschienen gelagert ist.

Insbesondere sieht die Erfindung vor, dass auf der Transportbahn aufeinanderfolgende Träger voneinander abweichende Aufnahmen für die ersten Fördereinrichtungen aufweisen, wobei die ersten Fördereinrichtungen derart auf die Träger ausgerichtet sind, dass der von einem der ersten Fördereinrichtungen erfasste Träger von der anderen ersten Fördereinrichtung unerfasst bleibt und umgekehrt.

Die ersten Fördereinrichtungen sind dabei vorzugsweise als Schubelemente wie -kolben oder -stangen ausgebildet, die vorzugsweise mit ihrem vorderen freien Ende in angepasste Aufnahmen der Träger eingreifen.

Hierzu ist insbesondere vorgesehen, dass von aufeinanderfolgenden Trägern in Transportrichtung betrachtet ein erster Träger eine parallel zur Transportrichtung verlaufende von einer ersten Fördereinrichtung durchsetzbare Durchbrechung wie Nut aufweist, der bzw. die auf eine Aufnahme des in Transportrichtung vorausgehenden Trägers ausgerichtet ist.

Eine Weiterbildung der Erfindung sieht vor, dass die zweite Fördereinrichtung in Form von Zugelementen wie -kolben oder -stangen ausgebildet ist. Dabei kann die zweite Fördereinrichtung die Träger über z. B. Magnete oder mechanische Kupplungen wie Klinken erfassen.

Die erste und/oder zweite Fördereinrichtung kann einen insbesondere über einen Spindelantrieb verschiebbaren Schlitten umfassen. Auch kann die erste und/oder die zweite Fördereinrichtung ein in einem Unterdruckbereich verstellbares Element wie Stange oder Kolben aufweisen, das über eine Vakuumdichtung mit einem Antrieb wie Zylinder oder Spindel verbunden ist.

Nach einem eigenerfinderischen Vorschlag der Erfindung weist der einen Gegenstand aufnehmende Träger einen Rahmen mit Eckstücken und diese verbindende Rahmenschenkel wie Keramikstangen auf, wobei diagonal gegenüberliegende Eckstücke über Spannelemente verbunden sind.

Die Rahmenschenkel selbst sind gleitend auf die die Transportbahn bildenden Schienen abgestützt.

Von den Rahmen selbst können parallel zueinander verlaufende Spannelemente wie über Federn aufgespannte Drähte als Auflage für zumindest einen Gegenstand ausgehen. Dabei können zur Unverrückbarkeit des Gegenstandes die Spannelemente Fixierelemente wie aufgepresste Metallkugeln zur Festlegung des Gegenstandes aufweisen.

Die Übergabeeinrichtung zum Aufnehmen bzw. Entnehmen des Gegenstandes auf die bzw. von der Transportbahn kann ebenfalls als linear wirkende hin und her bewegende Fördereinrichtung in Form z. B. einer Schub- bzw. Zugstange ausgebildet sein.

Konkret umfasst die Anordnung insbesondere drei Paare von Schubstangen, zwei Paare von Ziehstangen sowie Werkstückträger, wobei über die Schubstangen und Ziehstangen ein Übergang von einer getakteten Eingabe der Werkstückträger in eine kontinuierliche Bewegung und aus dieser der Übergang in eine wiederum getaktete Ausgabe ermöglicht wird. Dabei können die Werkstückträger über ein Paar von Ziehstangen seitlich auf eine Transportstrecke gezogen werden, zwei parallel arbeitende Paare von Schubstangen für eine kontinuierliche Bewegung einer lückenlosen Reihe von zumindest zwei Werkstückträgern auf der Transportbahn sorgen, die ihrerseits eine Bearbeitungseinrichtung durchsetzt, die von den Werkstückträgern mit einer konstanten oder nahezu konstanten Geschwindigkeit durchfahren wird. Die Werkstückträger selbst werden nach Durchfahren der Bearbeitungseinrichtung durch ein Paar von Ziehstangen auf eine Endposition der Transportbahn gezogen, von der ein Paar von Schubstangen die Werkstückträger seitlich von der Transportbahn herunterschiebt.

Die Werkstückträger umfassen einen Gleitrahmen, wobei zwei unterschiedlich ausgeformte Gleitrahmen alternierend transportiert werden.

Die Transportbahn umfasst ein System von Führungsschienen, die zusammen mit den Gleitrahmen ein Gleitsystem bilden.

Innerhalb des Gleitrahmens der Werkstückträger sind parallel zueinander verlaufende Drähte über Federn aufgespannt, die als Auflage für plattenförmige Gegenstände dienen. Auf den Drähten selbst können Metallkugeln aufgepresst sein, durch die die Lage der plattenförmigen Gegenstände in der Drahtebene definiert und eine Lagenänderung der Gegenstände selbst verhindert wird.

Mit der erfindungsgemäßen Lehre wird ein konstruktiv einfach aufgebautes Transportsystem zur Verfügung gestellt, mittels dessen eine lückenlose Reihe von Werkstückträgern auf eine als Führungsschienensystem ausgebildete Transportbahn mit konstanter Geschwindigkeit durch eine Beschichtungseinrichtung gefördert werden kann. Ein entsprechendes Transportsystem ist unkritisch bezüglich hoher Temperaturen und parasitärer Beschichtung, da sich im Beschichtungsbereich selbst keine bewegten Teile der Transportmechanik befinden. Durch das Zusammenwirken von zwei linear wirkenden eine Hin- und Herbewegung ausübenden Fördereinrichtungen in Form von Schubstangen in Verbindung mit zwei unterschiedlich ausgeformten Werkstoffträgern wird eine getaktete z. B. für den Durchtritt durch ein Vakuumschleusensystem erforderliche Bewegung der Werkstückträger in eine kontinuierliche Bewegung mit konstanter Vorschubgeschwindigkeit zum Behandeln der Gegenstände transformiert.

Des Weiteren werden aufgrund der erfindungsgemäßen Lehre Werkstückträger zur Verfügung gestellt, die eine minimale Wärmekapazität und einen maximalen Leitwert für eine den Träger senkrecht durchtretende Gasströmung aufweisen. Die innerhalb des Gleitrahmens aufgespannten Drähte besitzen aufgrund ihres geringen Durchmessers eine minimale Masse, so dass der Energieverlust durch Wärmeaustrag über die Werkstückträgermasse minimiert wird. Durch die Aufspannung der Drähte über Federn ist das Drahtfeld auch bei hohen Temperaturen vollständig verzugsfrei. Neben den aufgelegten Gegenständen kann durch den Zwischenraum zwischen den Drähten Gas strömen. Der Leitwert für diese Gasströmung wird fast ausschließlich über den Abstand der aufgelegten Gegenstände bestimmt und ist somit für jeden vorgegebenen Abstand maximal. Damit ist der Werkstoffträger optimal geeignet für den Einsatz in einseitig gepumpte Schleusenkammern mit hohen Durchsatzanforderungen. Eine Verschiebung flächiger Werkstücke wird auf einfache Weise durch z.B. Metallkugeln, die auf die Drähte aufgepresst werden können, verhindert.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine Prinzipdarstellung einer Anordnung zum Behandeln von flächigen Gegenständen,
- Fig. 2: eine Prinzipdarstellung eines Werkstückträgers in Vorderansicht,
- Fig. 3: eine Prinzipdarstellung eines Werkstückträgers in Draufsicht und
- Fig. 4: einen Ausschnitt des Werkstückträgers nach Fig. 3.

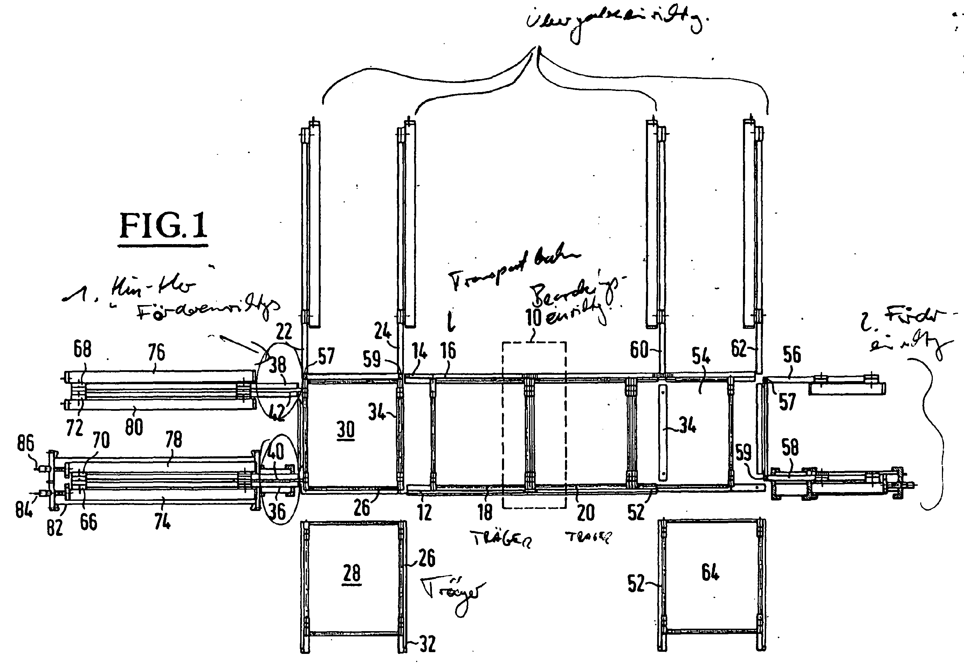

In Fig. 1 ist rein prinzipiell eine Anordnung zum Transportieren von flächigen Gegenständen wie insbesondere Siliziumwafern dargestellt, die in einer Bearbeitungseinrichtung 10 z. B. in Form einer Beschichtungszone durch Niederdruckgasphasenabscheidung behandelt, d. h. beschichtet werden soll. Die Anordung 10 umfasst eine durch Transportschienen 12, 14 gebildete Transportbahn 16, die die Bearbeitungs- oder Behandlungseinrichtung 10 durchsetzt und entlang der Werkstückträger 18, 20 förderbar ist, wobei innerhalb der Behandlungseinrichtung 10 selbst ein kontinuierlicher Transport erfolgt. Auf den Werkstückträgern 18, 20 sind zumindest ein, vorzugsweise mehrere flächige Gegenstände wie Siliziumwafer fixiert, um in der Behandlungseinrichtung 10 wie Beschichtungszone behandelt, also beschichtet zu werden.

Die Anordnung umfasst des Weiteren eine Übergabeeinrichtung in Form von Ziehstangen 22, 24, über die ein Werkstückträger 26 von einer Aufgabenposition 28 auf die Transportbahn 16 transportiert wird, um auf dieser eine Position 30 einzunehmen. Hierzu wird der Werkstückträger 26 auf Führungsschienen 32, 34 bewegt, wodurch ein ordnungsgemäßes Ausrichten auf die Transportbahn 16 und damit die Transportschienen 12, 14 sichergestellt ist. Dabei führen die Schienen 12, 14, 32, 34 die Werkstückträger 18, 20, 26 sowohl seitlich als auch im erforderlichen Umfang entlang deren Unter- und Oberseiten.

Sobald sich der Werkstückträger 26 in der Startposition 30 befindet, wird dieser von einer ersten von zwei linear wirkenden eine Hin- und Herbewegung ausübenden Fördereinrichtung in Form von einem Schubstangenpaar 36, 38 bzw. 40, 42 derart erfasst, dass der Werkstückträger 26 entlang der Transportbahn 16 an bereits auf dieser befindliche aneinandergereihte Werkstückträger 18, 20 angereiht wird. Die Schubstangen 36, 38 bzw. 40, 42 üben daher eine kurzandauernde schnelle Vorschubbewegung aus, die sodann in eine langandauernde langsame Vorschubbewegung konstanter Geschwindigkeit übergeht, um so die aneinandergereihten Träger 26, 18, 20 durch die Behandlungs- oder Bearbeitungseinrichtung 10 mit konstanter Geschwindigkeit zu fördern. Während der langsamen Vorschubbewegung der Schubstangenpaare 36, 38 bzw. 40, 42 schiebt der in Transportrichtung hinterste Träger 28 die in der Transportbahn 16 vor diesem befindlichen Träger 18, 20 an.

Bevor das Schubstangenpaar 36, 38 bzw. 40, 42 den sich in der Startposition 30 befindlichen Träger 26 an die bereits aneinandergereihten Werkstückträger 18, 20 angereiht hat, bewegt das andere mit dem zuvor letzten Werkstückträger - im Ausführungsbeispiel dem Werkstückträger 18 - in Eingriff befindliche Schubstangenpaar 40, 42 bzw. 36, 38 die aneinandergereihten Werkstückträger 18, 20 mit konstanter Geschwindigkeit. Sobald jedoch der Werkstückträger 28 an den Werkstückträger 18 angestoßen und ein weiterer Transport durch das Werkstückträgerpaar 36, 38 bzw. 40, 42 erfolgt, wird das andere Werkstückpaar 40, 42 bzw. 36, 38 zurückgezogen, um einen weiteren in die Startposition 30 mittels der Zugstangen 22, 24 bewegten Werkstückträger in zuvor beschriebener Weise entlang der Transportbahn 16 zu verschieben.

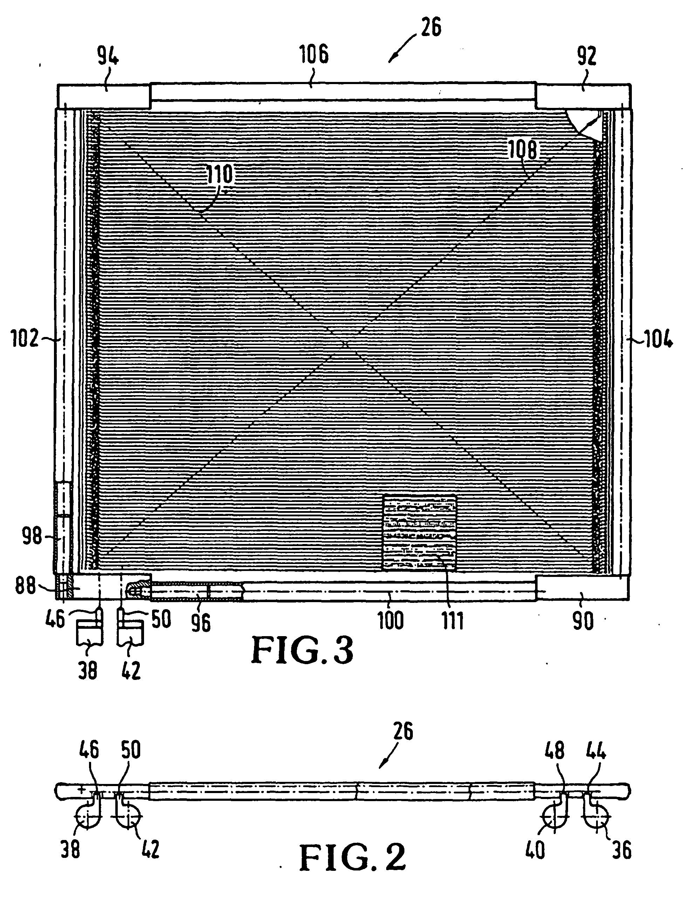

Wie anhand der Fig. 2 verdeutlicht werden soll, verlaufen die Schubstangenpaare 36, 38 bzw. 40, 42 in einer Ebene unterhalb der des Werkstückträgers 26, um in nachstehend beschriebener Art und Weise sicherzustellen, dass entlang der Transportbahn 16 verschiebbare Werkstückträger eine Behinderung für die Schubstangenpaare 36, 38 bzw. 40, 42 nicht darstellen können, um also Werkstückträger in die Startposition 30 zu bewegen und diese sodann im gewünschten Umfang entlang der Transportbahn 16 verschieben zu können.

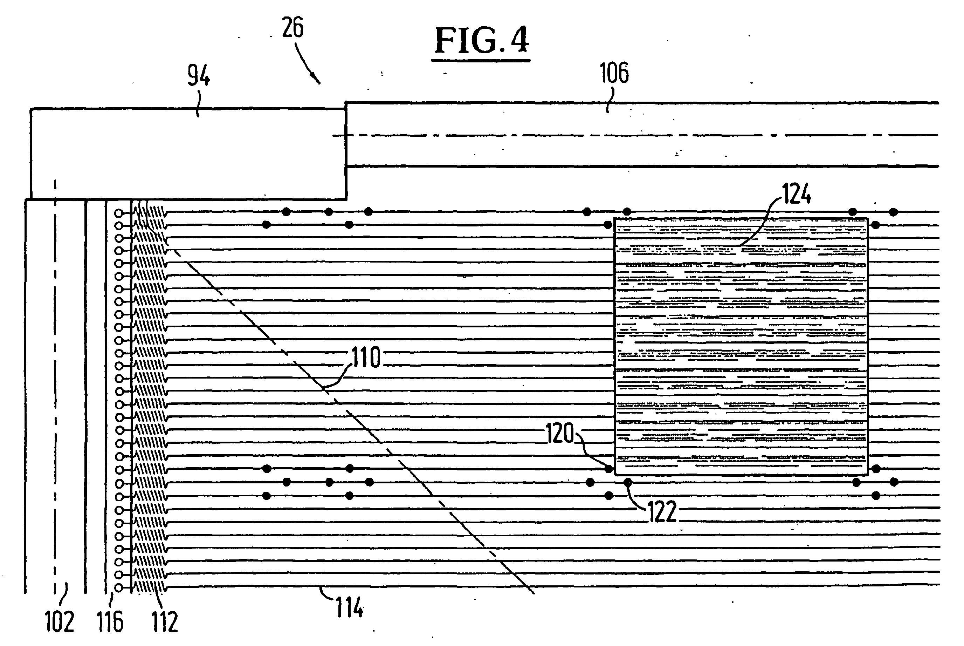

Wie die Fig. 2 und 3 zeigen, gehen von dem freien Ende der Schubstangenpaare 36, 38 bzw. 40, 42 als Spitzen ausgebildete Mitnehmer 44, 46 bzw. 48, 50 aus, die entsprechend der Fig. 2 in die von den Werkstückträgern aufgespannten Ebene ragen, um in Abhängigkeit von der Ausbildung des Werkstückträgers diesen zu transportieren oder durchsetzen zu können.

Erfindungsgemäß werden zwei unterschiedliche Werkstückträgertypen verwendet, die alternierend entlang der Transportbahn 16 verschoben werden. So besitzt z. B. der Werkstückträgertyp 26 z. B. Bohrungen, in die die Mitnehmer 44, 46 des Schubstangenpaares 36, 38 eingreifen können. Hiedurch besteht die Möglichkeit, dass beim Bewegen des Schubstangenpaares 36, 38 in Richtung der Behandlungs- oder Bearbeitungseinrichtung 10 der Werkstückträger 26 erfasst und somit entlang der Transportbahn 16 verschoben wird. Gleichzeitig kann das Schubstangenpaar 40, 42 ohne Behinderung durch den Werkstückträger 26 unter diesem verfahren werden, um beim Aneinanderreihen des Trägers 28 an den Träger 18 zurückgezogen zu werden; denn das Schubstangenpaar 40, 42 hat während des getakteten Zuführens des Trägers 26 mittels des Schubstangenpaares 36, 38 die aneinandergereihten Träger 18, 20 mit konstanter Geschwindigkeit entlang der Transportbahn 16 verschoben. Hierzu weist der Träger 26 im Bereich der Verschiebewege der Vorsprünge 48, 50 entsprechende Aussparungen wie Nuten auf, die in Bezug auf den vorauseilenden Träger - im Ausführungsbeispiel dem Träger 18 - in entsprechende Aufnahmen für die Mitnehmer 48, 50 der Schubstangen 40, 42 übergehen.

Durch die entsprechende Ausgestaltung bzw. Ausbildung der Werkstückträger 26, 18, 20 ist in zuvor beschriebener Art und Weise ein Bewegen der Werkstückträger 18, 20, 26 entlang der Transportbahn 16 derart möglich, dass jeder Träger von der Ausgangsposition 30 zunächst mit relativ hoher Geschwindigkeit entlang der Transportbahn 16 bis zum Aneinanderreihen an die bereits auf der Transportbahn 16 befindlichen Werkstückträger verschoben wird, um sodann mit gleichbleibender Geschwindigkeit zusammen mit den so aneinandergereihten Werkstückträgern weiterbewegt zu werden, wobei gleichzeitig ungehindert das zuvor die konstante Transportgeschwindigkeit erzeugende Schubstangenpaar durch den in Transportrichtung letzten Werkstückträger hindurchgefahren werden kann. Die Geschwindigkeit während der gleichbleibenden Bewegung ist selbstverständlich kleiner als die in dem getakteten Verschieben.

Sind im Ausführungsbeispiel Schubstangenpaare 36, 38, 40, 42 mit als Spitzen 44, 46, 48, 50 ausgebildete Mitnehmer dargestellt, so sind auch andere die gleiche Funktion und Aufgabe erfüllende Lösungsmöglichkeiten möglich wie z. B. entlang der Förderrichtung klappbare Klinken oder drehbare Mitnehmer, um im gewünschten Umfang mit den Werkstückträgern in zuvor beschriebener Weise in Eingriff bzw. Ausgriff zu gelangen.

Sobald ein Werkstückträger 52 vollständig die Behandlungs- oder Bearbeitungseinrichtung 10 durchlaufen hat, wird dieser durch Wegziehen von den ansonsten aneinandergereihten Werkstückträgern 18, 20 vereinzelt, um in eine Entnahmeposition 54 mittels Zugstangen 56, 58 bewegt zu werden, von der der Werkstückträger 52 aus der Transportbahn 16 in eine Position 64 transportiert wird, die als Vakuumschleuse ausgebildet sein kann, um den Werkstückträger 52 und damit die auf diesem angeordneten Gegenstände im erforderlichen Umfang weiterzubearbeiten.

Das Zugstangenpaar 56, 58 kann sich in der von dem Werkstückträger 52 aufgespannten Ebene bewegen, um mittels z. B. Magnet- oder mechanischer Kupplung 57, 59 wie Klinke den Werkzeugträger 52 zu erfassen. Eine gleiche Verbindungsart ist für die Zugstangen 22, 24 denkbar, mittels der der Werkstückträger 26 ebenfalls von z. B. einer durch die Position 28 angedeutete Schleuse in die Ausgangsposition 30 auf der Transportbahn 16 gezogen wird.

Dabei können die Zugstangen 56, 58 an ihrem jeweiligen vorderen Ende einen Elektromagneten aufweisen, denen jeweils ein ferritischer Einsatz in der zugewandten Rahmenseite des Trägers 52 zugeordnet ist.

Im Ausführungsbeispiel der Fig. 1 sind die Schub- und Zugstangen 36, 38, 40, 42 auf Linearschlitten 66, 68, 70, 72 mit Spindelantrieb 74, 76, 78, 80 montiert. Der Antrieb der Spindeln 74, 76, 78, 80 kann dabei über nicht näher bezeichnete Elektromotoren erfolgen. Auch den Schubstangen 60, 62 bzw. Zugstangen 22, 24, 56, 58 kann über nicht näher bezeichnete Linearschlitten mit Spindelantrieb die erforderliche linear wirkende Hin- und Herbewegung aufgeprägt werden.

Sofern der Transport der Werkstückträger 18, 20, 26, 52 durch ein Niederdrucksystem erfolgt, müssen die linearen Antriebseinheiten ebenfalls bei Niederdruck arbeiten. Die Spindelantriebe 74, 76, 78, 80 sind dann in Rohrgehäusen 82 gekapselt. Die Spindelantriebe 74, 76, 78, 80 sind ferner an Vakuumdrehdurchführungen 84, 86 angekuppelt, so dass die Antriebsmotoren atmosphärenseitig betrieben werden können.

Alternativ zu elektromotorisch angetriebenen Spindeln 74, 76, 78, 80 können lagergeregelte pneumatische oder hydraulische Zylinder als Antrieb für die Schub- und Zieh- bzw. Zugstangen 36, 38, 40, 42, 60, 62 bzw. 22, 24, 56, 58 eingesetzt werden.

Die Werkstückträger selbst, von denen in den Fig. 2 und 3 rein prinzipielle Werkstückträger 26 dargestellt sind, umfassen erfindungsgemäß Eckstücke 88, 90, 92, 94, die im Ausführungsbeispiel als Quader ausgebildet sind und die zuvor beschriebenen Aufnahmen bzw. Durchbrechungen wie Nuten aufweisen, um im erforderlichen Umfang mit den Mitnehmern 44, 46, 48, 50 der Schubstangenpaare 36, 38, 40, 42 zusammenzuwirken. Von jedem Eckstück 88, 90, 92, 94 gehen Dorne 96, 98 aus, die z. B. aus Keramikstangen 100, 102, 104, 106 bestehende Rahmenschenkel aufnehmen, die zusammen mit den Eckstücken 88, 90, 92, 94 einen Rahmen des Werkstückträgers 38 bilden. Der Rahmen selbst wird über diagonal gegenüberliegende Eckstücke 88, 92 bzw. 90, 94 verbindende Verspannungen 108, 110 zusammengehalten.

Die Durchmesser und Gestaltungen der Keramikrohre 100, 102, 104, 106 sind derart, dass diese zumindest außen-, unter- und oberseitig die Eckstücke 88, 90, 92, 94 überragen, so dass die Rahmenschenkel 100, 102, 104, 106 gleitend auf den Führungsschienen abstützbar sind, die die Transport- und Zufuhr- bzw. Wegführbahnen der Anordnung gemäß Fig. 1 bilden. Anstelle von Keramik können noch andere geeignete Materialien benutzt werden.

Wie die Draufsicht des Werkstückträgers 26 in Fig. 3 verdeutlicht, können auf diesem eine Vielzahl von flächigen Gegenständen 111 gelagen werden, die sodann gleichzeitig in der Behandlungseinrichtung 10 behandelt wie beschichtet werden.

Ein Ausschnitt des Werkstückträgers 26 ist in der Fig. 4 zu entnehmen, wobei gleiche Elemente mit gleichen Bezugszeichen versehen sind.

Zwischen den Rahmenschenkeln 102, 104 verlaufen über Federn 112 gespannte Drähte 114. Dabei gehen die Federn 112 von Einhängestangen 116 aus, die mit den Eckstücken 88, 94 bzw. 90, 92 in nicht näher bezeichneter Weise verbunden sind. Auf den Drähten 114 selbst sind im gewünschten Abstand zueinander Fixierpunkte wie Metallkugeln 120, 122 aufgepresst, wodurch die Position eines Gegenstandes 124 festgelegt wird. Hierdurch ist sichergestellt, dass auf der von den Drähten 114 aufgespannten Auflagefläche des Werkstückträgers 26 angeordnete flächige Gegenstände 111, 124 nicht verrutschen können und diese zueinander einen gewünschten Abstand einhalten.

Anstelle der Verwendung von zwei alternierend durchlaufenden unterschiedlichen Werkstückträgern ist es auch möglich, mit nur einem Werkstückträgertyp zu arbeiten. In diesem Fall sind die Schubstangen mit klappbaren Klinken oder drehbaren Mitnehmern auszustatten, um eine Kollision der jeweils freigewordenen und zurückfahrenden Schubstange mit dem vom zweiten Schubstangenpaar angeschobenen hintersten Werkstückträger zu vermeiden.

## Patentansprüche

1. Verfahren zum kontinuierlichen Behandeln von Gegenständen in einer Bearbeitungseinrichtung, insbesondere zur Oberflächenbehandlung von plattenförmigen Gegenständen (111, 124) wie Halbleiterbauelementen, vorzugsweise Siliziumwafern, wobei die Gegenstände entlang einer die Bearbeitungseinrichtung (10) durchsetzenden Transportbahn (16) mittels einer ersten linear wirkenden eine Hin- und Herbewegung ausübenden Fördereinrichtung (36,38,40,42) bewegt werden und wobei die Gegenstände über eine Übergabeeinrichtung (22, 24, 60, 62) auf die Transportbahn aufgegeben bzw. von dieser entnommen werden,
**dadurch gekennzeichnet,**
**dass** die Gegenstände auf Trägern (18, 20, 26, 52) angeordnet werden, die mittels zumindest zwei erste linear wirkende eine Hin- und Herbewegung ausübende Fördereinrichtungen auf der Transportbahn aneinandergereiht und sodann kontinuierlich durch die Bearbeitungseinrichtung gefördert werden, wobei das Aneinanderreihen und sodann kontinuierliche Fördern der Träger derart erfolgt, dass eine der ersten Fördereinrichtungen einen auf die Transportbahn übergebenen Träger an auf der Transportbahn vorhandenen Trägern anreiht, während die andere erste Fördereinrichtung die zuvor aneinandergereihten Träger kontinuierlich fördert.

2. Verfahren nach Anspruch 1,
**dadurch gekennzeichnet,**
**dass** ein die Bearbeitungseinrichtung verlassender Träger von den verbleibenden aneinandergereihten Trägern durch eine zweite Fördereinrichtung vereinzelt und auf eine den Träger von der Transportbahn wegführende Übergabeeinrichtung ausrichtet.

3. Verfahren nach Anspruch 1,
**dadurch gekennzeichnet,**
**dass** die Träger durch die Bearbeitungseinrichtung mit im Wesentlichen konstanter Geschwindigkeit gefördert werden.

4. Anordnung zur kontinuierlichen Behandlung wie Oberflächenbehandlung von auf Trägern (18, 20, 26, 52) angeordneten Gegenständen, insbesondere plattenförmigen Gegenständen (111, 124) wie Halbleiterbauelementen, vorzugsweise Siliziumwafern, umfassend eine eine Bearbeitungseinrichtung (10) durchsetzende Transportbahn (16) sowie Übergabeeinrichtungen (22, 24, 60, 62) zum Aufgeben bzw. Entnehmen der Träger auf die bzw. von der Transportbahn,
**dadurch gekennzeichnet,**
**dass** der Transportbahn (16) zum Transportieren der die Gegenstände aufnehmenden Träger (26) vor der Bearbeitungseinrichtung (10) zumindest zwei erste linear wirkende eine Hin- und Herbewegung ausübende Fördereinrichtungen (36, 38; 40, 42) zum getakteten Anreihen von Trägern (26) an auf der Transportbahn aneinander gereihten Trägern (18, 20) und zum kontinuierlichen Fördern durch die Bearbeitungseinrichtung zugeordnet sind und dass der Transportbahn zum Fördern von behandelte Gegenstände aufweisenden Trägern (52) zumindest eine zweite Fördereinrichtung (56, 58) zum Vereinzeln von auf die Übergabeeinrichtung (60, 62) aneinander gereihten Trägern zugeordnet ist.

5. Anordnung nach Anspruch 4,
**dadurch gekennzeichnet,**
**dass** jede erste Fördereinrichtung ein Paar (36, 38; 40, 42) von über z. B. einen Spindelantrieb oder über pneumatisch oder hydraulisch betätigbare Zylinder angetriebene Schubstangen umfasst und/oder dass die der Transportbahn (16) zugeordnete zweite Fördereinrichtung zum Vereinzeln von zuvor aneinandergereihten Trägern (52) eine zweite linear wirkende eine Hin- und Herbewegung ausübende Fördereinrichtung (56, 58) ist, wobei insbesondere die zweite Fördereinrichtung ein Paar von z. B. über eine Spindel oder einen pneumatisch oder hydraulisch betätigten Zylinder angetriebenen Zugstangen (56, 58) umfasst

6. Anordnung nach Anspruch 4 oder 5,
**dadurch gekennzeichnet,**
**dass** die Übergabeeinrichtung zum Aufgeben des Trägers (26) auf die und/oder zum Entnehmen des Trägers (52) von der Transportbahn (16) eine linear wirkende eine Hin- und Herbewegung ausübende Fördereinrichtung (42, 24, 60, 62) insbesondere in Form von Schub- oder Zugstangen ist.

7. Anordnung nach einem der Ansprüche 4 bis 6,
**dadurch gekennzeichnet,**
**dass** der Träger (26) einen Rahmen aufweist, der auf der die Transportbahn (16) vorgebenden Führungsschienen (12, 14) gelagert ist, dass der Rahmen Eckstücke (88, 90, 92, 94) und diese verbindende Rahmenschenkel (100, 102, 104, 106) umfasst, wobei insbesondere diagonal gegenüberliegende Eckstücke über Spannelemente (108, 110) verbunden sind, und dass die Rahmenschenkel (100, 102, 104, 106) gleitend auf der die Transportbahn bildenden Schienen abgestützt sind.

8. Anordnung nach einem der Ansprüche 4 bis 7,
**dadurch gekennzeichnet,**
**dass** von dem Rahmen parallel zueinander verlaufende Spannelemente (114) wie über Federn (112) aufgespannte Drähte (114) als Auflage für die Gegenstände (111, 124) ausgehen, wobei von den Spannelementen Fixierelemente wie aufgepresste Metallkugeln (120, 122) zur Festlegung der Gegenstände (124) ausgehen.

9. Anordnung nach einem der Ansprüche 4 bis 8,
**dadurch gekennzeichnet,**
**dass** auf der Transportbahn (16) angeordnete aufeinanderfolgende Träger (18, 20) voneinander abweichende Aufnahmen für die ersten Fördereinrichtungen (36, 38; 40, 42) aufweisen.

10. Anordnung nach einem der Ansprüche 4 bis 9,
**dadurch gekennzeichnet,**
**dass** die ersten Fördereinrichtungen (36, 38; 40, 42) derart auf die Träger (18, 20) ausgerichtet sind bzw. die Träger zueinander derart abweichend ausgebildet sind, dass der von einem der ersten Fördereinrichtungen erfasste Träger von der anderen ersten Fördereinrichtung unerfasst bleibt und umgekehrt, wobei insbesondere die erste Fördereinrichtung zumindest ein Schubelement wie -kolben oder -stange (36, 38; 40, 42) aufweist, die mit einem Mitnehmer wie an ihrem vorderen freien Ende vorhandene Spitze (44, 46; 48, 50) in eine dieser angepasste Aufnahme des Trägers (26) eingreift.

11. Anordnung nach einem der Ansprüche 4 bis 10,
**dadurch gekennzeichnet,**
**dass** von aufeinanderfolgenden Trägern (18, 20) in Transportrichtung betrachtet ein erster Träger eine parallel zur Transportrichtung verlaufende von einer der ersten Fördereinrichtung (36, 38; 40, 42) durchsetzbare Durchbrechung wie Nut aufweist, die in die Aufnahme des in Transportrichtung vorausgehenden Trägers ausgerichtet ist.

12. Anordnung nach einem der Ansprüche 4 bis 11,
**dadurch gekennzeichnet,**
**dass** die zweite Fördereinrichtung (56, 58) mit dem Träger (52) über z. B. eine magnetische oder mechanische Kupplung wie Klinke lösbar verbindbar ist und/oder dass die zweite Fördereinrichtung mit ihrem mit dem Träger wechselwirkenden Bereich einen Elektromagneten aufweist, der mit trägerseitig vorhandenen ferritischen Einsätzen wechselwirkt.

13. Anordnung nach Anspruch 7,
**dadurch gekennzeichnet,**
**dass** die Werkstückträger gleich ausgebildet sind und die ersten Fördereinrichtungen zum abwechselnden Erfassen von aufeinanderfolgenden Werkstückträgern vorzugsweise klappbare Klinken oder drehbare Mitnehmer aufweisen.

## Claims

1. Method for continuous treatment of objects in a processing unit, in particular for surface treatment of plate-like objects (111, 124) such as semiconductor elements, preferably silicon wafers, whereby the objects are moved along a conveyor track (16) passing through the processing unit (10) by means of a first linearly acting conveying device (36, 38, 40, 42) performing a back-and-forward movement and whereby the objects are fed to the conveyer track and taken from this, respectively, by means of a transfer device (22, 24, 60, 62),
**characterized in**
**that** the objects are arranged on supports (18, 20, 26, 52) which are lined up on the conveyor track by means of at least two first linearly acting conveying devices performing a back-and-forward movement and then conveyed continuously through the processing unit, whereby the lining up and then continuous conveying of the support is performed such that one of the first transfer devices lines up a support fed to the conveyor track to supports present on the conveyor track, while the other conveying device conveys continuously the supports previously lined up.

2. Method according to claim 1,
**characterized in**
**that** a support exiting the processing unit is separated from the remaining lined-up supports by a second conveying device and aligned with a transfer device leading the support away from the conveyor track.

3. Method according to claim 1,
**characterized in**
**that** the supports are conveyed through the processing unit at a substantially constant speed.

4. Arrangement for continuous treatment such as surface treatment of objects arranged on supports (18, 20, 26, 52), in particular plate-like objects (111, 124) such as semiconductor elements, preferably silicon wafers, comprising a conveyor track (16) passing through a processing unit (10) as well as transfer units (22, 24, 60, 62) for feeding the supports to the conveyor track and for taking them from it, respectively,
**characterized in**
**that** at least two first linearly acting conveying devices (36, 38; 40, 42) performing a back-and-forward movement are assigned to the conveyor track (16) for transporting the support (26) receiving the objects in front of the processing unit (10) for pulsed lining up of supports (26) to supports (18, 20) lined up on the conveying track und for continuous conveying through the processing unit, and that at least a second conveying device (56, 58) is assigned to the conveying track for conveying supports (52) having treated objects to separate supports lined up on the transfer unit (60, 62).

5. Arrangement according to claim 4,
**characterized in**
**that** each fist conveying device comprises a pair (36, 38; 40, 42) of pusher rods driven e.g. by a spindle drive or by pneumatically or hydraulically operated cylinders and/or that the second conveying device assigned to conveyor track (16) for separating previously lined up supports (52) is a second linearly acting conveying device (56, 58) performing a back-and-forward movement, whereby in particular the second conveying device comprises a pair of tie rods (56, 58) driven e.g. by a spindle or by pneumatically or hydraulically operated cylinders.

6. Arrangement according to claim 4 or 5,
**characterized in**
**that** the transfer device for feeding the support (26) onto and/or for removing the support (52) from the conveyor track (16) is a linearly acting conveying device (42, 24, 60, 62) performing a back-and-forward movement in particular in the form of pusher rods or tie rods.

7. Arrangement according to one of claims 4 to 6,
**characterized in**
**that** the support (26) comprises a frame arranged on the guide rails (12, 14) defining the conveyor track (16), that the frame comprises corner pieces (88, 90, 92, 94) and frame legs (100, 102, 104, 106) connecting the corner pieces, whereby in particular diagonally opposite corner pieces are connected by tensioning elements (108, 110), and that the frame legs (100, 102, 104, 106) are supported in sliding fashion on the rails forming the conveyor track.

8. Arrangement according to one of claims 4 to 7,
**characterized in**
**that** clamping elements (114) such as wires (114) clamped by springs and running in parallel to each other extend from the frame as rest for the objects (111, 124), whereby fixing elements such as pressed on metal balls (120, 122) for immobilizing the objects (124) extend from the tensioning elements.

9. Arrangement according to one of claims 4 to 8,
**characterized in**
**that** consecutive supports (18, 20) arranged on the conveyor track (16) have differing receptacles for the first conveying devices (36, 38; 40, 42).

10. Arrangement according to one of claims 4 to 9,
**characterized in**
**that** the first conveying devices (36, 38; 40, 42) are aligned with the supports (18, 20) or the supports are designed differently from one another in such a way that the support gripped by one of the first conveying devices remains ungripped by the other first conveying device and vice versa, whereby in particular the first conveying device comprises a pusher element such as piston or rod (36, 38; 40, 42), that engages with a carrier such as a tip (44, 46; 48, 50) at its front free end into a receptacle of the support (26) adapted to said tip.

11. Arrangement according to on of claims 4 to 10,
**characterized in**
**that** viewed in transportation direction a first support of successive supports (18, 20) has a recess such as groove running in parallel to the transport direction that can be passed through by the first conveying device (36, 38; 40, 42), said recess being aligned with the receptacle of the preceding support in the transport direction.

12. Arrangement according to one of claims 4 to 11,
**characterized in**
**that** the second conveying device (56, 58) is connectable to the support (52) via e.g. a magnetic or mechanical coupling means such as catch and/or that the second conveying device comprises a solenoid that interacts with ferrite inserts provided on the support side.

13. Arrangement according to claim 7,
**characterized in**
**that** work piece supports are of identical design and the first conveying devices comprise preferably collapsing catches or rotatable drivers for alternating gripping of consecutive workpiece supports.

## Revendications

1. Procédé de traitement en continu d'objets dans une installation de traitement, notamment pour le traitement en surface d'objets en forme de plaques (111, 124) tels que des composants semi-conducteurs, de préférence des plaquettes de silicium, selon lequel on déplace les objets le long d'un chemin de transport (16) traversant l'installation de traitement (10) à l'aide d'un premier convoyeur (36, 38, 40, 42) linéaire, effectuant un mouvement de va-et-vient, et on distribue ou on extrait les objets du chemin de transport par une installation de transfert (22, 24, 60, 62),
**caractérisé en ce que**
les objets se trouvent sur des supports (18, 20, 26, 52) qui sont rangés à l'aide de deux premiers convoyeurs sur le chemin de transport, ces convoyeurs linéaires effectuant un mouvement de va-et-vient et ensuite ils sont transportés en continu à travers l'installation de traitement,
le rangement et ensuite le transfert en continu des supports se faisant en ce qu'un des premiers convoyeurs range un support à transférer au chemin de transport contre les supports qui se trouvent déjà sur le chemin de transport pendant que l'autre premier convoyeur transfère en continu les supports rangés au préalable.

2. Procédé selon la revendication 1,
**caractérisé en ce qu'**
un support quittant l'installation de traitement est séparé des supports rangés les uns contre les autres, restants, par un second convoyeur et il est aligné dans une installation de transfert qui évacue le support du chemin de transport.

3. Procédé selon la revendication 1,
**caractérisé en ce que**
les supports sont transférés à travers l'installation de traitement à vitesse essentiellement constante.

4. Dispositif pour le traitement en continu tel qu'un traitement de surface d'objets portés par des supports (18, 20, 26, 52), notamment d'objets en forme de plaques (111, 124) tels que des composants semi-conducteurs et de préférence des plaquettes de silicium comprenant un chemin de transport (16) traversant une installation de traitement (10) ainsi que des installations de transfert (22, 24, 60, 62) pour fournir ou prélever des supports du chemin de transport,
**caractérisé en ce que**
pour transporter les supports (26) recevant les objets, on associe au chemin de transport (16) au moins deux premiers convoyeurs (36, 38 ; 40, 42) linéaires, exécutant un mouvement de va-et-vient, en amont de l'installation de traitement (10), pour ranger de manière cadencée les supports (26) contre des supports (18, 20) déjà rangés les uns contre les autres sur le chemin de transport et pour les convoyer en continu à travers l'installation de traitement, et
on associe au chemin de transport au moins un second convoyeur (56, 58) pour convoyer des supports (52) munis d'objets traités, ce second convoyeur servant à séparer les supports rangés les uns contre les autres dans l'installation de transfert (60, 62).

5. Dispositif selon la revendication 4,
**caractérisé en ce que**
chaque premier convoyeur comporte une paire (36, 38, 40, 42) de barres de poussée entraînée par exemple par un entraînement à broche ou un vérin pneumatique ou hydraulique, et/ou le second convoyeur associé au chemin de transport (16) comporte pour séparer des supports (52) préalablement rangés, une seconde installation de transport (56, 58) linéaire, exécutant un mouvement de va-et-vient, et notamment le second convoyeur a une paire de barres de traction (56, 58) entraînée par exemple par l'intermédiaire d'une broche ou d'un vérin à commande pneumatique ou hydraulique.

6. Dispositif selon la revendication 4 ou 5,
**caractérisé en ce que**
l'installation de transfert servant à transférer le support (26) au chemin de transport (16) et/ou à prélever le support (52) du chemin de transport (16), est constituée par un convoyeur (42, 24, 60, 62) à effet linéaire, exécutant un mouvement de va-et-vient, notamment sous la forme de barres de poussée ou de traction.

7. Dispositif selon l'une des revendications 4 à 6,
**caractérisé en ce que**
le support (26) comporte un cadre monté sur les rails de guidage (12, 14) définissant le chemin de transport (16),
le cadre comporte des coins (88, 90, 92, 94) et des branches de cadre (100, 102, 104, 106) qui les relient,
et en particulier les coins opposés en diagonal sont reliés par des éléments de serrage (108, 110), et
les branches (100, 102, 104, 106) du cadre sont appuyées de manière glissante sur les rails formant le chemin de transport.

8. Dispositif selon l'une des revendications 4 à 7,
**caractérisé en ce que**
des éléments de tension (14) partant parallèlement du cadre tels que des fils (114) tendus par des ressorts (112) servent d'appui aux objets (111, 124), et des éléments de fixation partant des éléments tendeurs tels que des billes métalliques (120, 122), pressées, servent à fixer les objets (124).

9. Dispositif selon l'une des revendications 6 à 8,
**caractérisé en ce que**
des supports (18, 20) installés les uns à la suite des autres sur le chemin de transport (7) comportent des logements différents les uns des autres pour le premier convoyeur (36, 38, 40, 42).

10. Dispositif selon l'une des revendications 4 à 9,
**caractérisé en ce que**
les premiers convoyeurs (36, 38, 40, 42) sont alignés sur les supports (18, 20) ou les supports sont réalisés différemment les uns des autres de façon que le premier support saisi par le premier convoyeur ne soit pas saisi par l'autre premier convoyeur et inversement, et notamment le premier convoyeur comporte au moins un élément de poussée tel qu'un piston ou une tige (36, 38, 40, 42) dont la pointe (44, 46, 48, 50) équipant un organe d'entraînement tel que l'extrémité avant libre, pénètre dans un logement adapté du support (26).

11. Dispositif selon l'une des revendications 4 à 10,
**caractérisé en ce que**
vu dans la direction de transport à partir des supports (18, 20) successifs, un premier support a un passage parallèle à la direction de transport et traversé par l'un des premiers convoyeurs (36, 38, 40, 42), tel qu'une rainure alignée sur le logement du support en amont dans la direction de transport.

12. Dispositif selon l'une des revendications 4 à 11,
**caractérisé en ce que**
le second convoyeur (56, 58) est relié de manière amovible au support (52) par exemple par un accouplement magnétique ou mécanique tel qu'un verrou, et/ou le second convoyeur comporte un électro-aimant coopérant avec des zones alternées du support, cet électro-aimant coopérant de façon alternée avec des inserts ferritiques prévus du côté du support.

13. Dispositif selon la revendication 7,
**caractérisé en ce que**
les supports de pièce sont réalisés de façon identique et les premiers convoyeurs comportent de préférence des verrous basculants ou des organes d'entraînement pivotants pour saisir alternativement des supports de pièce successifs.
